# EUROPÄISCHE PATENTSCHRIFT

(11) **EP 2 454 926 B1**
(45) Veröffentlichungstag und Bekanntmachung des Hinweises auf die Patenterteilung: **18.12.2019**
(21) Anmeldenummer: 10729802.8
(22) Anmeldetag: 24.06.2010
(51) Int. Cl.: H05K 7/14, H05K 7/20

(54) **GEHÄUSE FÜR EINE ELEKTRONISCHE VORRICHTUNG**
HOUSING FOR AN ELECTRONIC DEVICE
BOÎTIER DE DISPOSITIF ÉLECTRONIQUE

(30) Priorität: 14.07.2009 DE 102009033258
(43) Veröffentlichungstag der Anmeldung: 23.05.2012
(73) Patentinhaber: SEW-EURODRIVE GmbH & Co. KG, 76646 Bruchsal (DE)
(72) Erfinder: KARST, Andreas, 75239 Elsingen (DE); HUBER, Martin, 77830 Bühlertal (DE); JUNGINGER, Alexander, 75196 Remchingen-Wilferdingen (DE)
(86) Internationale Anmeldenummer: PCT/EP2010/003887
(87) Internationale Veröffentlichungsnummer: WO 2011/006583

(56) Entgegenhaltungen:
- EP-A1- 0 954 210
- EP-A1- 1 467 406
- EP-A1- 1 996 004
- DE-A1-102004 034 834
- DE-T2- 60 309 150
- DE-T2- 69 202 405

## Beschreibung

Die Erfindung betrifft ein Gehäuse.

**Aus der** EP 0 954 210 A1 **ist eine Kühlanordnung für ein Elektronikgerät bekannt.**

**Aus der** EP 1 996 004 A1 **ist ein Wechselrichtergehäuse bekannt.**

**Aus der** EP 1 467 406 A1 **ist ein modular aufgebautes Leistungshalbleitermodul bekannt.**

**Aus der** DE 10 2004 034 834 A1 **ist ein Baukasten von Gehäusen bekannt.**

Der Erfindung liegt daher die Aufgabe zugrunde, ein Gehäuse flexibler, sicherer und einfacher montierbar auszuführen.

Erfindungsgemaß wird die Aufgabe bei dem Gehäuse nach den in Anspruch 1 angegebenen Merkmalen gelöst.

Wichtige Merkmale der Erfindung bei dem Gehäuse sind, dass das einen Innenraum umschließende Gehäuse Gehäuseteile und einen als Kühlkörper ausgebildeten Boden umfasst, wobei mehrere Formteile in dem Innenraum des Gehäuses zusammen mit dem Boden mehrere Raumbereiche untereinander und zum restlichen Innenraum elektrisch und thermisch begrenzen. Von Vorteil ist dabei, dass die einzelnen Raumbereiche und der restljche Innenraum besser nutzbar sind, da elektrische und thermische Beeinflussungen verringert sind.

Bei einer vorteilhaften Ausgestaltung ist der Boden modular aus einem oder mehreren Bodenteilen aufgebaut und das eine oder die mehreren Formteile im Innenraum des Gehäuses das Bodenteil oder die mehreren Bodenteile zumindest teilweise abdeckt beziehungsweise abdecken. Von Vorteil ist dabei, dass die Bodenteile vormontierbar sind.

Erfindungsgemäß ist mindestens ein Formteil ein derart gefaltetes Stanzteil, dass eine haubenartige Form gebildet ist. Von Vorteil ist dabei, dass das Formteil einfach herstellbar und einfach lagerbar ist.

Erfindungsgemäß ist mindestens ein Formteil in einem Kunststofftiefziehprozess derart hergestellt, dass eine haubenartige Form gebildet ist. Von Vorteil ist dabei, dass das Formteil einfach in komplexen Formen herstellbar ist.

Bei einer weiteren vorteilhaften Ausgestaltung ist mindestens ein Formteil aus einem Thermoplast, insbesondere Polypropylen, vorzugsweise einem flammhemmenden Polypropylen, hergesteilt. Von Vorteil ist dabei, dass das Formteil auch in komplizierten Formen einfach herstellbar ist.

Bei einer weiteren vorteilhaften Ausgestaltung weist das Polypropylen eine Durchschlagsfestigkeit von 19,7 bis 106 kV/mm (500 bis 2700 Volt/mil) insbesondere von 39,4 bis 78,7 kV/mm (1000 bis 2000 Volt/mil), auf. Von Vorteil ist dabei, dass die Raumbereiche gut elektrische voneinander isoliert sind.

Bei einer weiteren vorteilhaften Ausgestaltung weist der Boden, beziehungsweise das Bodenteil, Kühlrippen an einer Außenseite des Gehäuses auf. Von Vorteil ist dabei, dass elektronische Bauteile in den Raumbereichen gut kühlbar sind.

Erfindungsgemäß deckt jedes der Formteile eine Baueinheit der elektronischen Vorrichtung ab. Bei einer weiteren vorteilhaften Ausgestaltung deckt je ein separates Formteil jede Baueinheit der elektronischen Vorrichtung ab. Von Vorteil ist dabei, dass das Gehäuse einfacher montierbar ist und die Raumbereiche auch vor allem bei der Montage und dem Versand mechanisch geschützt sind.

Bei einer weiteren vorteilhaften Ausgestaltung folgt das Formteil mit seiner Form einer gedachten, enganliegenden Einhüllenden der Baueinheit. Von Vorteil ist dabei, dass der Innenraum gut ausnutzbar ist.

Bei einer weiteren vorteilhaften Ausgestaltung weist die Baueinheit wärmeerzeugende Bauelemente auf, welche auf einer Leiterplatte angeordnet sind, wobei die wärmeerzeugenden Bauelemente mit dem Boden thermisch leitend verbunden sind, insbesondere über eine Struktur mit einer Wärmeleitfähigkeit von grösser als 2.5 W/(mK). Von Vorteil ist dabei, dass die Bauelemente gut entwärmt werden ohne den restlichen Innenraum oder andere Raumbereich thermisch zu belasten.

Bei einer weiteren vorteilhaften Ausgestaltung weist das Formteil ein Loch auf, welches zum Durchführen eines Befestigungsmittels zum Befestigen des Formteils an dem Bodenteil dient. Von Vorteil ist dabei, dass das Formteil einfach am Bodenteil befestigbar ist.

Bei einer weiteren vorteilhaften Ausgestaltung umfassen die Gehäuseteile einen Deckel, Wände und Eckteile, wobei die Eckteile die Wände verbinden und der Deckel über die Wände und/oder die Eckteile mit dem Boden verbunden sind. Von Vorteil ist dabei, dass das Gehäuse modular aufbaubar ist und somit einfach in verschiedenen Größen fertigbar ist.

Bei einer weiteren vorteilhaften Ausgestaltung weisen das Bodenteil oder die mehreren Bodenteile im wesentlichen eine rechteckige Form auf, wobei zwei sich gegenüberliegende Kanten des Bodenteils oder der mehreren Bodenteile als eine Nut oder eine Nase ausgebildet sind, wobei die Nut und die Nase zweier nebeneinander angeordneter Bodenteile ineinander greifen. Von Vorteil ist dabei, dass die Bodenteile sicher und einfach zusammenfügbar sind.

Bei einer weiteren vorteilhaften Ausgestaltung ist der Boden an den Kanten des Bodenteils bzw. der mehreren Bodenteile, welche als Nut oder Nase ausgebildet sind mit je einem entsprechend ausgeführten Endstück abgeschlossen, wobei das entsprechende Endstück entweder eine Nut oder eine Nase aufweist und die der Nut oder der Nase gegenüberliegende Kante des Endstücks eben ist. Von Vorteil ist dabei, dass das Gehäuse einfach modular montierbar ist.

Bei einer weiteren vorteilhaften Ausgestaltung sind zwei benachbarte Bodenteile durch ein zusätzliches Verbindungselemente verbunden, insbesondere verschraubt, wobei das Verbindungselement vorzugsweise elektrische und/oder thermisch leitend ist. Von Vorteil ist dabei, dass die Bodenteile sicher und steif miteinander verbunden sind und ein definiertes gleiches elektrisches Potential gegenüber der auf Ihnen montierten Leiterplatte besitzen.

Weitere Vorteile ergeben sich aus den Unteransprüchen.

Die Erfindung wird nun anhand von Ausführungsbeispielen mit Bezugnahme auf die Zeichnung näher erläutert. Es zeigen rein schematisch:
- Fig. 1: eine dreidimensionale Draufsicht eines erfindungsgemäßen Gehäuse
- Fig. 2: ein Stanzteil für ein erfindungsgemäßes Gehäuse in ungefaltetem Zustand;
- Fig. 3: eine Isometrie des in Figur 1 gezeigten Stanzteils gefaltet und auf ein Bodenteil eines erfindungsgemäßen Gehäuses montiert;
- Fig. 4: das in Figur 3 gezeigte Stanzteil in Draufsicht;
- Fig. 5: eine Seitenansicht des in Figur 3 gezeigten Stanzteils;
- Fig. 6: eine Isometrie eines in einem Kunststofftiefziehprozess hergestellten Formteils;
- Fig. 7: eine Draufsicht des in Figur 6 gezeigten Formteils;
- Fig. 8: ein Längsschnitt durch das in Figur 6 gezeigte Formteil;
- Fig. 9: ein Querschnitt durch das in Figur 6 gezeigte Formteil;
- Fig. 10: das in Figur 6 gezeigte Formteil auf ein Bodenteil montiert; und
- Fig. 11: eine weitere Ausführungsform eines Formteils in montiertem Zustand für ein erfindungsgemäßes Gehäuse.

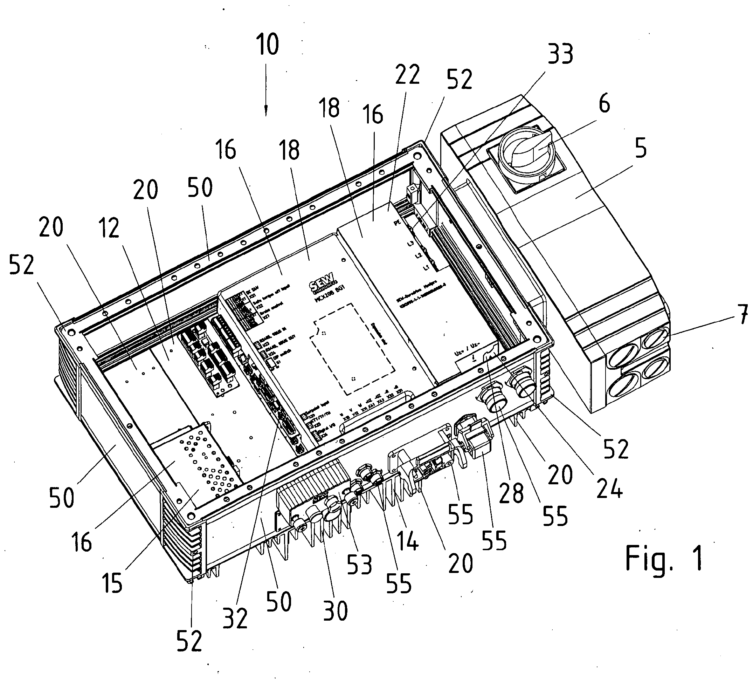

Die Figur 1 zeigt ein erfindungsgemäßes Gehäuse 10 für einen Umrichter zur Ansteuerung eines Elektromotors. Das erfindungsgemäße Gehäuse 10 umfasst neben dem nicht gezeigten Deckel einen Boden 14, Wände 50 und Eckteile 52. Der Boden 14 ist aus einzelnen Bodenteilen 20 zusammengesetzt. Die Gehäuseteile und insbesondere der Deckel, sind auch durch entsprechende Formgestaltung mit vergrößerter Oberfläche als erweiternde Kühlflächen nutzbar. Das Gehäuse 10 umschließt einen annähernd quaderförmigen Innenraum 12.

Im Innenraum 12 des Gehäuses 10 sind drei Formteile 16 angeordnet. Eines der Formteile 16 ist als zusammengefaltetes Stanzteil 22 ausgeführt. Das andere Formteil 16 ist als Tiefziehteil 17 durch einen Kunststofftiefziehprozess hergestellt. Ein drittes Formteil 16 ist als Blechteil 15 ausgeführt. Das Blechteil 15 ist durch Falten oder Tiefziehen herstellbar. Als weitere Materialien zur Herstellung der Formteile 16 sind auch Metall, beschichtetes Metall, Kunststoff, getempertes Glas, PU-Schaum oder ähnliche Materialien denkbar.

Die Formteile 16 sind so im Innenraum 12 angeordnet, dass jeweils ein Raumbereich 18 des Innenraums 12 von den anderen Raumbereichen 18 und dem restlichen Innenraum elektrisch und thermisch begrenzt ist.

In den Raumbereichen 18 sind elektronische Vorrichtungen angeordnet. Die elektronischen Vorrichtungen sind an den Bodenteilen 20 befestigt und von den Formteilen 16 abgedeckt. Anschlusselemente für die elektronische Vorrichtung schauen aus dem jeweiligen Raumbereich 18 heraus.

Andere elektronische Vorrichtungen sind auf weiteren Bodenteilen 20 angeordnet, welche nicht von einem Formteil abgedeckt sind.

Zwischen dem nicht gezeigten Deckel und den Formteilen 16 lassen sich noch weitere elektronische Vorrichtungen im Innenraum 12 anbringen Zum Beispiel sind unter den Formteilen 16 Leistungsmodule des Umrichters, wie Gleichrichter, Zwischenkreiskondensatoren und Wechselrichter zur Ansteuerung eines Motors angeordnet. Im Weiteren Innenraum sind die weiteren elektronischen Vorrichtungen, wie zum Beispiel eine Steuerungselektronik zur Auswertung und Verarbeitung von Steuersignalen einer übergeordneten Steuerung und eine Ansteuerungselektronik für den Wechselrichter im Gehäuse 10 eingebaut.

Das Bodenteil 20 weist einen quaderförmigen Grundkörper auf. An die vom Innenraum 12 abgewandte Fläche der Bodenteile 20 sind unterschiedlich ausgeformten Kühlrippen 30 angeformt. Das Bodenteil 20 ist vorzugsweise aus Aluminium insbesondere einstückig hergestellt. Falls die Kühlleistung ohne Kühlrippen 30 ausreichend ist sind auch Bodenteile 20 ohne Kühlrippen verwendbar.

Eine der Wände 50 ist optional durch ein außerhalb des Gehäuses 10 angeordnetes Schaltelement 5 ersetzbar. Das Schaltelement 5 dient als Schalter für den Umrichter. Dazu weist das Schaltelement 5 einen Drehschalter 6 und Kabeldurchführungen 7 auf. Als weitere nicht gezeigte Optionen zur Erweiterung des Gehäuses 10 sind an eine der Wände 50 die elektrischen Komponenten von Hilfsachsen, Netzteilen, I/O-Erweiterungen oder ähnliche Steuer- oder Antriebselementen ein- oder anbaubar.

Eine Wand 50 des Gehäuses 10 ist als Anschlussleiste 54 ausgeführt und weist Kabeldurchführungen mit weiteren Steckverbindungen 55 auf. An die weiteren Steckverbindungen 55 sind zum Beispiel Steuerungsbusleitungen, wie zum Beispiel PROFIBUS, DeviceNet oder Ethernet-Feldbus oder Elektromotorversorgungskabel anschließbar. Andere der weiteren Steckverbindungen erlauben den Anschluss eines externen Bremswiderstands oder den Anschluss eines Drehzahlgebers des vom Umrichter versorgten Elektromotors. Weiter ist auch ein Bus-Modul 53 anschließbar, mit welchem von außen die Busadresse des Umrichters einstellbar ist, ohne das Gehäuse 10 zu öffnen.

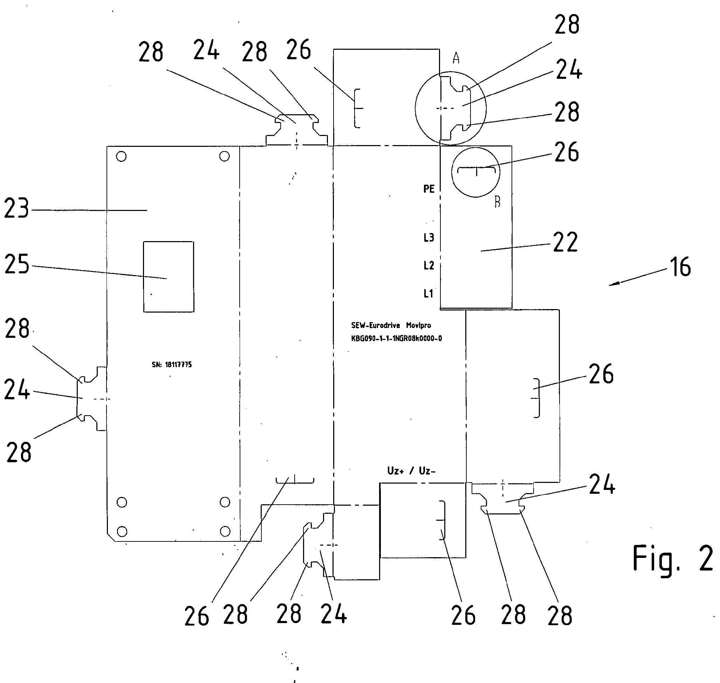

Figur 2 zeigt eine Draufsicht auf das Stanzteil 22. Das Stanzteil 22 entspricht einem Netz eines zu faltenden Formteils 16. Zum Stabilisieren des gefalteten Stanzteils 22 umfasst das Stanzteil 22 Klemmlaschen 24 und zu den Klemmlaschen 24 korrespondierende Schlitze 26. In gefaltetem Zustand greifen die Klemmlaschen 24 in die Schlitze 36 ein.

Die Klemmlaschen 24 weisen dazu annähernd die Form von gleichschenkligen Trapezen auf, welche in den nicht parallelen Seitenlinien Ausnehmungen aufweisen, so dass am schmalen Ende der gleichschenkligen Trapeze eine Art von seitlich abstehenden Widerhaken 28 ausgeformt ist. Diese Widerhaken 28 halten die Klemmlaschen 24 in den Schlitzen 26.

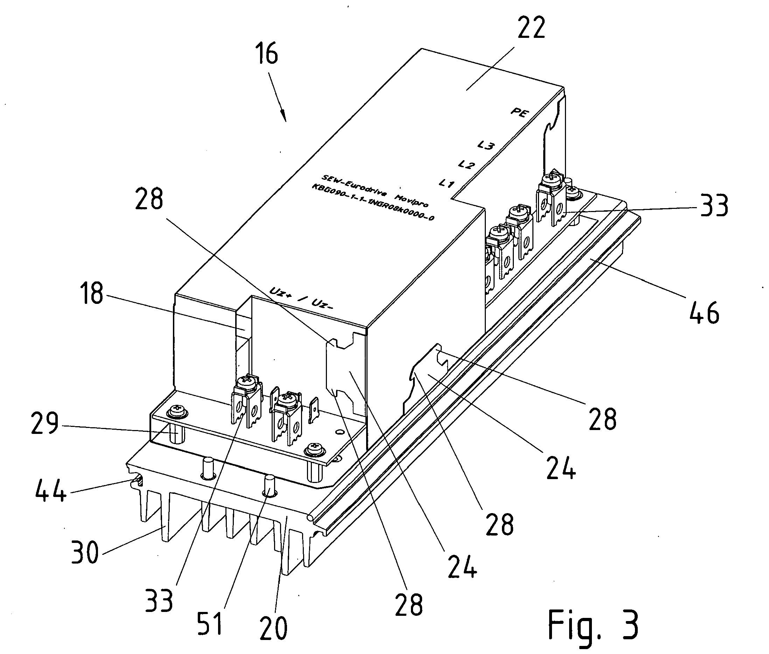

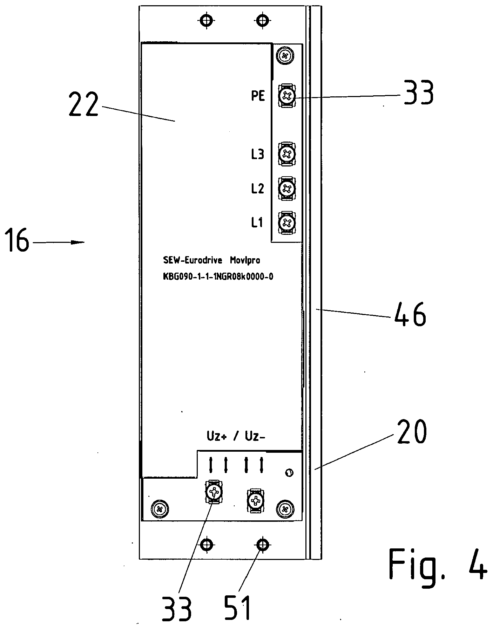

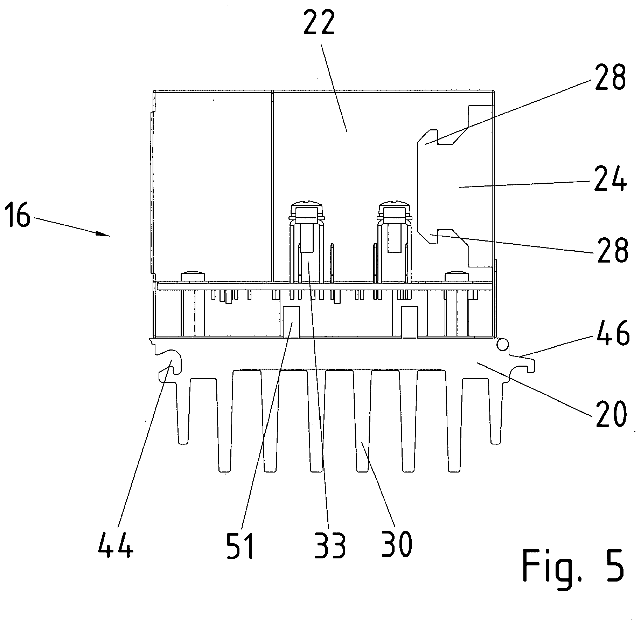

Die Figuren 3, 4 und 5 zeigen das Stanzteil 22 im zusammengefalteten Zustand. Das gefaltete Stanzteil 22 weist eine nahezu quaderförmige Form auf. Das gefaltete Stanzteil 22 ist auf einem Bodenteil 20 des erfindungsgemäßen Gehäuses montiert. Dazu ist ein Bodenabschnitt 23 des Stanzteils 22 mit dem Bodenteil 20 verschraubt. In einer alternativen Ausführung sind die Formteile auf dem Boden geklemmt oder mit Klemmelementen befestigt.

Das Stanzteil 22 und teilweise die Bodenplatte 20 begrenzen den Raumbereich 18. Der Raumbereich 18 ist von seiner Umgebung elektrisch und thermisch fast vollumfänglich isoliert. Dafür ist das Stanzteil aus einem Thermoplast insbesondere Polypropylen hergestellt ist, welches eine Durchschlagsfestigkeit von 19,7 bis 106 kV/mm (500 bis 2700 Volt/ mil). insbesondere von 39,4 bis 78,7 kV/mm (1000 bis 2000 Volt/mil). Der Thermoplast ist vorzugsweise flammhemmend beziehungsweise selbstverlöschend.

Im Raumbereich 18 ist der größte Teil einer Leiterplatte 32 angeordnet. Auf der Leiterplatte 32 ist vorzugsweise ein Gleichrichtermodul des Umrichters angeordnet. Die Leiterplatte 32 ist auf Abstandshaltern 29 mit dem Bodenteil 20 verschraubt. Die Abstandshalter 29 sind über Löchern des Bodenabschnitts 23 angeordnet, so dass die Leiterplatte 32 und das Stanzteil 22 mit denselben Schrauben am Bodenteil 20 verschraubt sind Die elektronischen Bauteile auf der Leiterplatte 32 sind somit besser thermisch und elektrisch abgeschirmt.

Auf der anderen Seite ist die thermische Belastung der Umgebung der Leiterplatte durch wärmeerzeugende Bauelemente auf der Leiterplatte 32 reduziert beziehungsweise größtenteils auf den Raumbereich 18 beschränkt. Ein weiterer Vorteil ist der mechanische Schutz der Leiterplatte 32 und besonders der elektronischen Bauteile. Dies erlaubt eine vereinfachte Montage des aus den Bodenteilen 20 und den weiteren Gehäuseteilen aufgebauten Gehäuses 10.

Formteile aus Metall oder einem Metall aufweisenden Material bieten den Vorteil einer Abschirmung gegenüber Elektromagnetischen Störungen und verbessen so die elektromagnetische Verträglichkeit. So sind auch empfindliche Steuerungselektronik und Leistungsteile im Gehäuse 10 anordenbar.

Der Bodenabschnitt 23 weist gegebenenfalls eine Öffnung 25 auf. Durch diese Öffnung 25 sind wärmeerzeugende Bauelemente, welche auf der Leiterplatte 32 montiert sind, über eine wärmeleitende Struktur mit dem Bodenteil 20 thermisch verbunden.

Verbindungsabschnitte der Leiterplatte 32 schauen aus dem Raumbereich 18 hervor. Auf diesen Verbindungsabschnitten sind Mittel zur elektrischen Verbindung, vorzugsweise als Klemmvorrichtung 33, angeordnet. An die Klemmvorrichtungen 33 sind Leitungselemente zur elektrischen Leistungs- und/oder Signalübertragung anklemmbar.

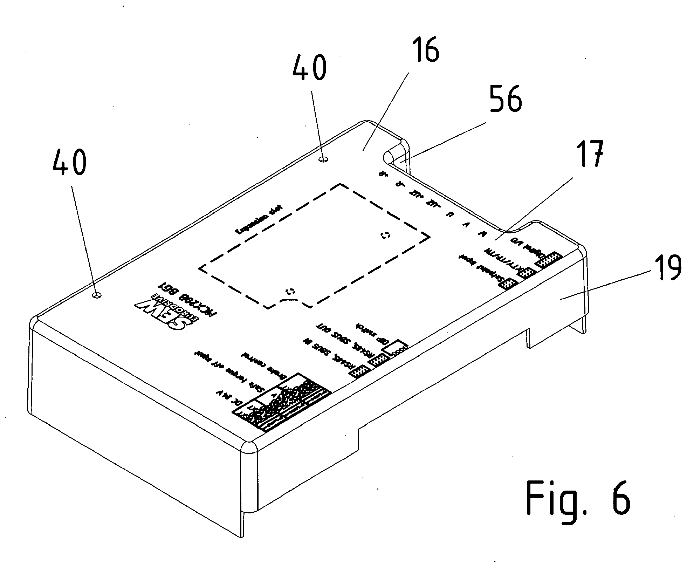

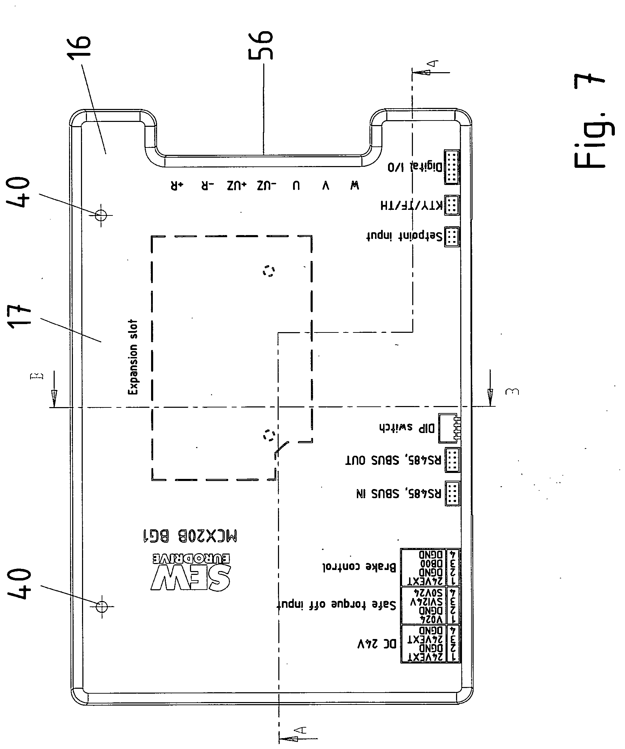

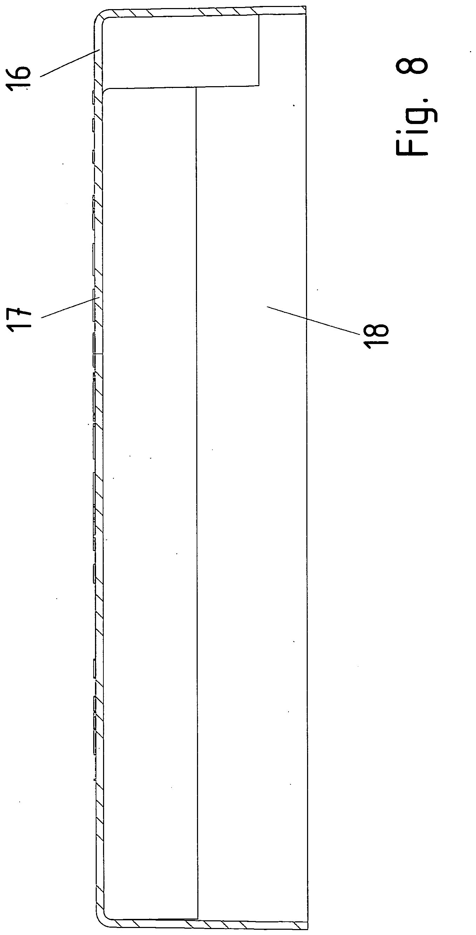

Die Figuren 6 bis 10 zeigen eine weitere erfindungsgemäße Ausführungsförm eines Formteils 16. Das in den Figuren 6 bis 10 gezeigte Formteil 16 ist in einem Kunststofftiefziehprozess als Tiefziehteil 17 hergestellt. Das Tiefziehteil 17 weist eine annähernd quaderförmige, haubenartige Form auf und ist aus einem Thermoplast, insbesondere Polypropylen mit einer elektrischen Durchschlagsfestigkeit zwischen 19,7 bis 106 kV/mm (500 bis 2700 Volt/mil) gefertigt.

Das Tiefziehteil 17 weist im Gegensatz zum Stanzteil 22 keinen Bodenabschnitt auf. Ein vom Tiefziehteil 17 eingeschlossene Raumbereich 18 ist mit dem entsprechenden Bodenteil 20 begrenzt. Wandabschnitte 19 zwischen der dem Bodenteil 20 abgewandten Seite und der Leiterplatte 32 beziehungsweise dem Bodenteil 20 stehen teilweise auf der Leiterplatte 32 auf. Andere Abschnitte der Wände reichen bis auf das Bodenteil 20 hinunter. Das Tiefziehteil 17 deckt vorzugsweise den Wechselrichter zur Ansteuerung eine Motors ab.

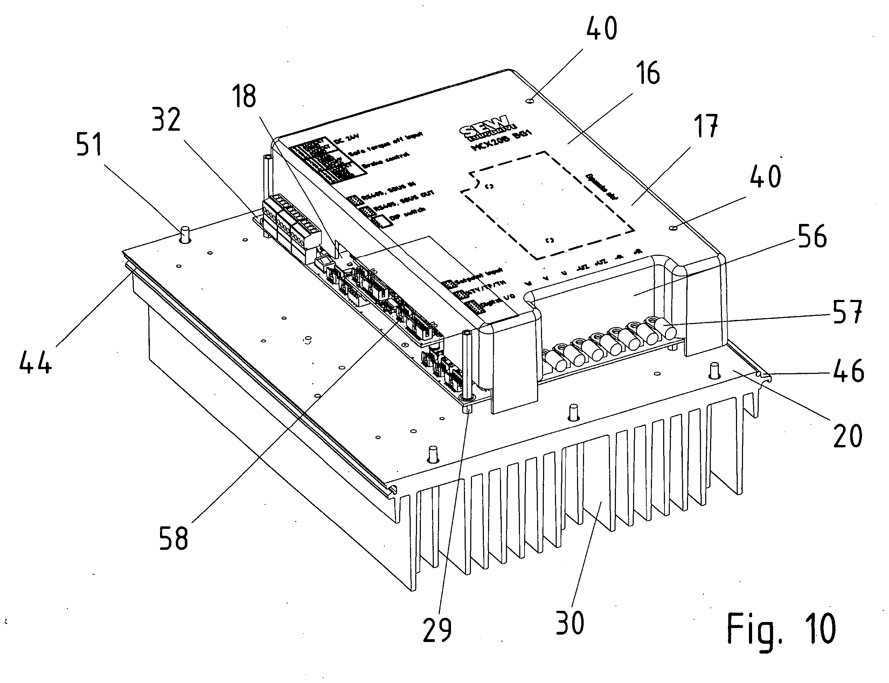

Im Raumbereich 18 ist eine Leiterplatte 32 angeordnet, welche an dem Bodenteil 20 verschraubt ist. Elektrische Anschlussbereiche der Leiterplatte 32 schauen unter dem Tiefziehteil 17 hervor. Dafür ist eine Wand des Tiefziehteils 17 nach innen gezogen und bildet so eine zurückgezogenen Wand 56. Somit sind elektrische Kontaktelemente, welche auf den elektrischen Anschlussbereichen angeordnet sind, zugänglich. In Figur 10 sind an der zurückgezogenen Wand 56 als elektrische Kontaktelemente Kabelschuhe 57 gezeigt. Weitere Kontaktelemente schauen an einer Seite das Tiefziehteils hervor. Ebenso schauen an dieser Seite Kontaktelemente einer Einsteckkarte 58 hervor. Die Position der Einsteckkarte 58 ist in Figur 10 durch eine eigentlich nicht sichtbare, durchgezogene Linie gezeigt. Die Einsteckkarte 58 ist in eine entsprechende Aufnahmehalterung auf der Leiterplatte 32 lösbar eingesteckt.

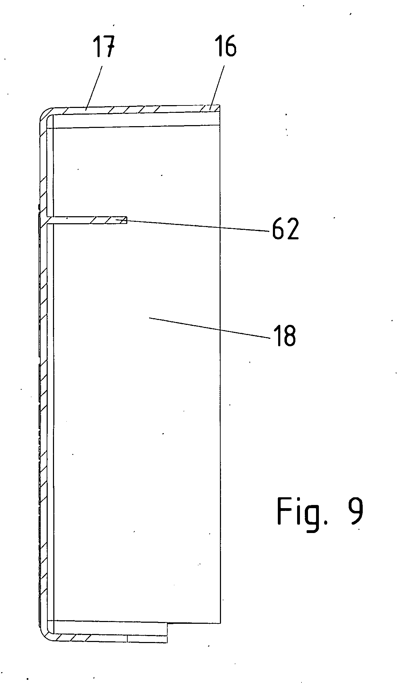

Figur 9 zeigt eine Zwischenwand 62 des Tiefziehteils 17. Mit Hilfe der Zwischenwand 62 lässt sich im Zusammenspiel mit den unter dem Tiefziehteil 17 angeordneten elektronischen Vorrichtungen der Raumbereich 18 weiter unterteilen.

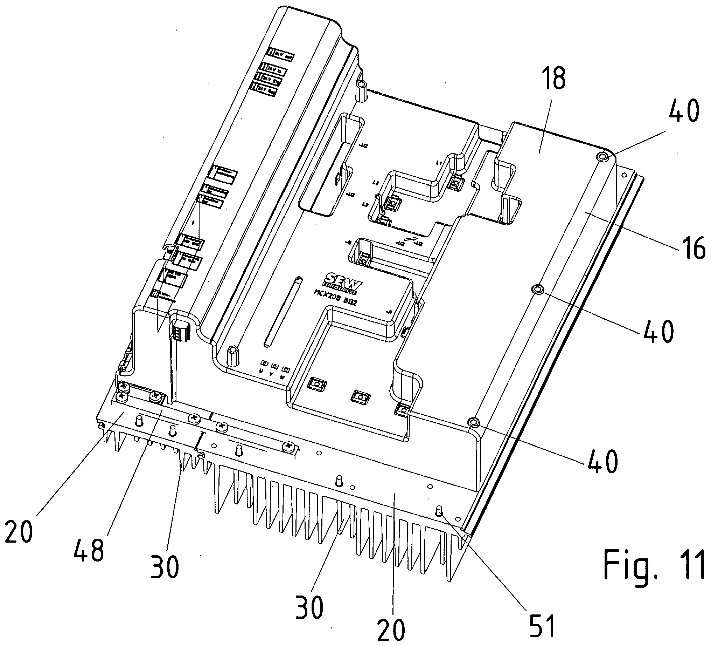

Figur 11 zeigt eine abgewandelte Ausführungsform der weiteren Ausführungsform des Formteils 16 für ein erfindungsgemäßes Gehäuse. Das in Figur 11 gezeigte Formteil 16 weist eine komplexere Form auf. Die Form folgt einer gedachten Einhüllenden der im vom Formteil 16 und zwei entsprechenden Bodenteilen 20 eingeschlossene Raumbereich angeordneten Leiterplatte 32. Aus dem Formteil 16 ragen elektrische Anschlussmittel heraus. Durch die Form sind elektrischen Anschlussmittel zum Anschließen elektrischer Leitungen besser zugänglich.

Die zwei Bodenteile 20 sind über ein Verbindungselement 48 miteinander verschraubt. Dies erlaubt einen thermischen Ausgleich und einen elektrischen Potentialausgleich.

In den Figuren 3 bis 5, 10 und 11 sind Haltelemente 51 gezeigt, mit denen die Wände 50 oder das Schaltelement 5 an dem Boden 14 des Gehäuses 10 befestigbar sind.

Das Bodenteil 20 oder die mehreren Bodenteile 20 weisen im Wesentlichen eine rechteckige Form auf. Zwei sich im zusammengebauten Gehäuse 10 gegenüberliegende Kanten des Bodenteils 20 oder der mehreren Bodenteile 20 sind als eine Nut 44 oder eine Nase 46 ausgebildet Die Nut 44 und die Nase 46 zweier nebeneinander angeordneter Bodenteile 20 greifen ineinander. Dadurch sind die Bodenteile 20 sicher und einfach zusammengefügt.

Die Kanten des Bodens 14 bzw. der entsprechen außen liegenden Bodenteile 20 welche als Nut 44 oder Nase 46 ausgebildet sind mit je einem entsprechend ausgeführten Endstück abgeschlossen, wobei das entsprechende Endstück entweder eine Nut 44 oder eine Nase 46 aufweist und die der Nut 44 oder der Nase 46 gegenüberliegende Kante des Endstücks eben ist. Vorzugsweise weisen die Endstücke eine außenliegende T-Nut auf, mit welcher das Gehäuse 10 einfach montierbar ist.

### Bezugszeichenliste

- 5: Schaltelement
- 10: Gehäuse
- 12: Innenraum
- 14: Boden
- 15: Blechteil
- 16: Formteil
- 17: Tiefziehteil
- 18: Raumbereich
- 19: Wandabschnitt
- 20: Bodenteil
- 22: Stanzteil
- 23: Bodenabschnitt
- 24: Klemmlaschen
- 25: Öffnung
- 26: Schlitze
- 28: Widerharken
- 30: Kühlrippen
- 32: Leiterplatte
- 33: Klemmvorrichtung
- 40: Loch
- 42: Steckverbindung
- 44: Nut
- 46: Nase
- 48: Verbindungselement
- 50: Wand
- 51: Halteelement
- 52: Eckteil
- 53: Bus-Modul
- 54: Anschlussleiste
- 55: weitere Steckverbindungen
- 56: zurückgezogene Wand
- 57: Kabelschuh
- 58: Einsteckkarte
- 60: elektrische Anschlussmittel
- 62: Zwischenwand

## Patentansprüche

1. Gehäuse (10) für eine elektronische Vorrichtung, wobei das Gehäuse einen Innenraum (12) umschließt und Gehäuseteile (50, 52) und einen als Kühlkörper ausgebildeten Boden (14) umfasst, wobei mehrere Formteile (16) in dem Innenraum (12) des Gehäuses zusammen mit dem Boden (14) mehrere Raumbereiche (18) untereinander und zum restlichen Innenraum (12) elektrisch und thermisch begrenzen,
und wobei jedes der Formteile (16) eine Baueinheit der elektronischen Vorrichtung abdeckt,
**dadurch gekennzeichnet, dass**
mindestens ein Formteil (16) ein gefaltetes Stanzteil (22) ist und eine haubenartige Form aufweist,
und dass mindestens ein Formteil (16) als Tiefziehteil (17) durch einen Kunststofftiefziehprozess hergestellt ist und eine haubenartige Form aufweist.

2. Gehäuse nach Anspruch 1,
**dadurch gekennzeichnet, dass**
der Boden (14) modular aus einem oder mehreren Bodenteilen (20) aufgebaut ist und das eine oder die mehreren Formteile (16) im Innenraum des Gehäuses das Bodenteil oder die mehreren Bodenteile zumindest teilweise abdeckt beziehungsweise abdecken.

3. Gehäuse nach mindestens einem der vorangegangenen Ansprüche, **dadurch gekennzeichnet, dass**
mindestens ein Formteil (16) aus einem Thermoplast, insbesondere Polypropylen, vorzugsweise einem flammhemmenden Polypropylen, hergestellt ist.

4. Gehäuse nach Anspruch 3, **dadurch gekennzeichnet, dass**
das Polypropylen eine Durchschlagsfestigkeit von 19,7 bis 106 kV/mm (500 bis 2700 Volt/mil), insbesondere von 39,4 bis 78,7 V/mm (1000 bis 2000 Volt/mil), aufweist.

5. Gehäuse nach mindestens einem der vorangegangenen Ansprüche, **dadurch gekennzeichnet, dass**
der Boden (14), beziehungsweise das Bodenteil (20), Kühlrippen (30) an einer Außenseite des Gehäuses (10) aufweist.

6. Gehäuse nach mindestens einem der vorangegangenen Ansprüche, **dadurch gekennzeichnet, dass**
je ein separates Formteil (16) jede Baueinheit der elektronischen Vorrichtung abdeckt.

7. Gehäuse nach Anspruch 1, **dadurch gekennzeichnet, dass**
das Formteil (16) mit seiner Form einer gedachten, enganliegenden Einhüllenden der Baueinheit folgt.

8. Gehäuse nach mindestens einem der vorangegangenen Ansprüche,
**dadurch gekennzeichnet, dass**
die Baueinheit wärmeerzeugende Bauelemente aufweist, welche auf einer Leiterplatte (32) angeordnet sind, wobei die wärmeerzeugenden Bauelemente mit dem Boden (14) thermisch leitend verbunden sind, insbesondere über eine Struktur mit einer Wärmeleitfähigkeit von grösser als 2.5 W/(mK).

9. Gehäuse nach mindestens einem der vorangegangenen Ansprüche, **dadurch gekennzeichnet, dass**
das Formteil (16) ein Loch (40) aufweist, welches zum Durchführen eines Befestigungsmittels zum Befestigen des Formteils an dem Boden (14) dient.

10. Gehäuse nach mindestens einem der vorangegangenen Ansprüche, **dadurch gekennzeichnet, dass**
die Gehäuseteile einen Deckel, Wände (50) und Eckteile (52) umfassen, wobei die Eckteile die Wände verbinden und der Deckel über die Wände und/oder die Eckteile mit dem Boden (14) verbunden sind.

11. Gehäuse nach Anspruch 2 **dadurch gekennzeichnet, dass**
das Bodenteil oder die mehreren Bodenteile (20) im wesentlichen eine rechteckige Form aufweisen, wobei zwei sich gegenüberliegende Kanten des Bodenteils oder der mehreren Bodenteile als eine Nut oder eine Nase ausgebildet sind, wobei die Nut und die Nase zweier nebeneinander angeordneter Bodenteile ineinander greifen.

12. Gehäuse nach Anspruch 2 **dadurch gekennzeichnet, dass**
die Kanten des Bodenteils bzw. der mehreren Bodenteile. (20), welche als Nut (44) oder Nase (46) ausgebildet sind, mit je einem entsprechend ausgeführten Endstück abgeschlossen sind, wobei das entsprechende Endstück entweder eine Nut oder eine Nase aufweist und die der Nut oder der Nase gegenüberliegende Kante eben ist.

13. Gehäuse nach Anspruch 2 **dadurch gekennzeichnet, dass**
zwei benachbarte Bodenteile (20) durch ein zusätzliches Verbindungselemente (48) verbunden sind, insbesondere verschraubt sind, wobei das Verbindungselement vorzugsweise elektrische und/oder thermisch leitend ist.

## Claims

1. A housing (10) for an electronic device,
wherein the housing encloses an interior (12) and comprises housing parts (50, 52) and a bottom (14) in the form of a cooling body,
wherein a plurality of shaped parts (16) in the interior (12) of the housing electrically and thermally delimit, together with the bottom (14), a plurality of spatial regions (18) with regard to one another and to the remainder of the interior (12),
and wherein each of the shaped parts (16) covers a structural unit of the electronic device,
**characterized in that**
at least one shaped part (16) is a folded stamped part (22) and has a hood-like form,
and **in that** at least one shaped part (16) is manufactured in a plastic deep drawing process as a deep-drawn part (17) and has a hood-like form.

2. A housing according to claim 1,
**characterized in that**
the bottom (14) is constructed in a modular manner from one or a plurality of bottom parts (20) and
the one or plurality of shaped parts (16) in the interior of the housing at least partially covers or cover the bottom part or the plurality of bottom parts.

3. A housing according to at least one of the preceding claims,
**characterized in that**
at least one shaped part (16) is manufactured from a thermoplastic, in particular polypropylene, preferably a flame-retarding polypropylene.

4. A housing according to claim 3,
**characterized in that**
the polypropylene has a dielectric strength from 19.7 to 106 kV/mm (500 to 2700 Volt/mil), in particular from 39.4 to 78.7 V/mm (1000 to 2000 Volt/mil).

5. A housing according to at least one of the preceding claims,
**characterized in that**
the bottom (14), or the bottom part (20), has cooling ribs (30) at an exterior of the housing (10).

6. A housing according to at least one of the preceding claims,
**characterized in that**
a respective separate shaped part (16) covers each structural unit of the electronic device.

7. A housing according to claim 1,
**characterized in that**
the form of the shaped part (16) follows a notional, close-fitting envelope of the structural unit.

8. A housing according to at least one of the preceding claims,
**characterized in that**
the structural unit has heat-generating structural elements which are arranged on a printed circuit board (32), wherein the heat-generating structural elements are connected to the bottom (14) in a thermally conducting manner, in particular via a structure with a thermal conductivity greater than 2.5 W/(mK).

9. A housing according to at least one of the preceding claims,
**characterized in that**
the shaped part (16) has a hole (40) which is used for the passage of a securing means for securing the shaped part to the bottom (14).

10. A housing according to at least one of the preceding claims,
**characterized in that**
the housing parts comprise a lid, walls (50) and corner parts (52),
wherein the corner parts connect the walls and the lid is connected to the bottom (14) via the walls and/or the corner parts.

11. A housing according to claim 2,
**characterized in that**
the bottom part or the plurality of bottom parts (20) has/have a substantially rectangular form, wherein two facing edges of the bottom part or the plurality of bottom parts are in the form of a groove or a projection wherein there is engagement of the groove and the projection of two bottom parts arranged alongside one another.

12. A housing according to claim 2,
**characterized in that**
the edges of the bottom part or the plurality of bottom parts (20), which edges are in the form of a channel (44) or a projection (46), are closed by a respective correspondingly formed end piece, wherein the corresponding end piece has either a channel or a projection and the edge facing the channel or the projection is plane.

13. A housing according to claim 2,
**characterized in that**
two adjacent bottom parts (20) are connected by an additional connecting element (48), in particular screwed together, wherein the connecting element is preferably electrically and/or thermally conductive.

## Revendications

1. Boîtier (10) pour un dispositif électronique,
sachant que le boîtier entoure un espace intérieur (12) et comprend des parties de boîtier (50, 52) et un fond (14) conçu comme corps de refroidissement,
sachant que plusieurs pièces façonnées (16) dans l'espace intérieur (12) du boîtier délimitent électriquement et thermiquement, conjointement avec le fond (14), plusieurs régions spatiales (18) les unes par rapport aux autres et par rapport au reste de l'espace intérieur (12),
et sachant que chacune des pièces façonnées (16) recouvre une unité modulaire du dispositif électronique,
**caractérisé en ce qu'**au moins une pièce façonnée (16) est une pièce découpée et pliée (22) et présente une forme du genre capot,
et **en ce qu'**au moins une pièce façonnée (16) est fabriquée sous forme de pièce emboutie (17) par un processus d'emboutissage profond de matière plastique et présente une forme du genre capot.

2. Boîtier selon la revendication 1, **caractérisé en ce que** le fond (14) est construit de manière modulaire à partir d'une ou plusieurs parties de fond (20),
et la ou les pièces façonnées (16) dans l'espace intérieur du boîtier recouvre ou recouvrent au moins partiellement la partie de fond ou les parties de fond.

3. Boîtier selon au moins une des revendications précédentes, **caractérisé en ce qu'**au moins une pièce façonnée (16) est fabriquée à partir d'une matière thermoplastique, en particulier de polypropylène, de préférence d'un polypropylène ignifuge.

4. Boîtier selon la revendication 3, **caractérisé en ce que** le polypropylène présente une rigidité diélectrique de 19,7 à 106 kV/mm (500 à 2700 volts/mil), en particulier de 39,4 à 78,7 kV/mm (1000 à 2000 volts/mil).

5. Boîtier selon au moins une des revendications précédentes, **caractérisé en ce que** le fond (14), ou plus précisément la partie de fond (20), présente des nervures de refroidissement (30) sur un côté extérieur du boîtier (10).

6. Boîtier selon au moins une des revendications précédentes, **caractérisé en ce qu'**une pièce façonnée (16) séparée respective recouvre chaque unité modulaire du dispositif électronique.

7. Boîtier selon la revendication 1, **caractérisé en ce que** la pièce façonnée (16) suit par sa forme une enveloppante imaginaire entourant étroitement l'unité modulaire.

8. Boîtier selon au moins une des revendications précédentes, **caractérisé en ce que** l'unité modulaire présente des composants producteurs de chaleur qui sont disposés sur une carte imprimée (32), sachant que les composants producteurs de chaleur sont reliés en conduction thermique au fond (14), en particulier par l'intermédiaire d'une structure ayant une conductibilité thermique supérieure à 2,5 W/(mK).

9. Boîtier selon au moins une des revendications précédentes, **caractérisé en ce que** la pièce façonnée (16) présente un trou (40) qui sert à faire passer un moyen de fixation destiné à fixer la pièce façonnée sur le fond (14).

10. Boîtier selon au moins une des revendications précédentes, **caractérisé en ce que** les parties de boîtier comprennent un couvercle, des parois (50) et des parties de coins (52),
sachant que les parties de coins relient les parois et que le couvercle est relié au fond (14) par l'intermédiaire des parois et/ou des parties de coins.

11. Boîtier selon la revendication 2, **caractérisé en ce que** la partie de fond ou les parties de fond (20) présentent pour l'essentiel une forme rectangulaire, sachant que deux bords se faisant face de la partie de fond ou des parties de fond sont réalisés sous la forme d'une rainure ou d'un tenon, sachant que la rainure et le tenon de deux parties de fond disposées l'une à côté de l'autre s'engagent l'un dans l'autre.

12. Boîtier selon la revendication 2, **caractérisé en ce que** les bords de la partie de fond ou des parties de fond (20) qui sont réalisés sous forme de rainure (44) ou de tenon (46) sont terminés par un embout respectif réalisé d'une manière correspondante, sachant que l'embout correspondant présente soit une rainure soit un tenon et que le bord faisant face à la rainure ou au tenon est plan.

13. Boîtier selon la revendication 2, **caractérisé en ce que** deux parties de fond voisines (20) sont reliées par un élément de liaison supplémentaire (48), en particulier sont reliées par vissage, sachant que l'élément de liaison est de préférence électriquement et/ou thermiquement conducteur.
